# EUROPEAN PATENT SPECIFICATION

(11) **EP 2 655 701 B1**
(45) Date of publication and mention of the grant of the patent: **29.08.2018**
(21) Application number: 10795732.6
(22) Date of filing: 23.12.2010
(51) Int. Cl.: C25D 5/02, C25D 7/12, H01L 21/3065, H01L 21/288

(54) **A METHOD FOR PROVIDING AN ECPR MASTER ELECTRODE AND AN ECPR MASTER ELECTRODE**
VERFAHREN ZUR BEREITSTELLUNG EINER ECPR-MASTERELEKTRODE UND EINE ECPR-MASTERELEKTRODE
PROCÉDÉ POUR OBTENIR UNE ÉLECTRODE-MAÎTRE DE TYPE ECPR ET UNE ÉLECTRODE-MAÎTRE DE TYPE ECPR

(43) Date of publication of application: 30.10.2013
(73) Proprietor: Luxembourg Institute of Science and Technology (LIST), 4362 Esch-sur-Alzette (LU)
(72) Inventor: DAINESE, Matteo, F-38000 Grenoble (FR); CUTHBERTSON, Alan, F-38320 Herbeys (FR); FREDENBERG, Mikael, S-112 34 Stockholm (SE); MÖLLER, Patrik, S-112 52 Stockholm (SE); VAN DEN HOEK, Wilbert, Saratoga, CA 95070 (US); ARONSSON, Cecilia, S-174 47 Sundbyberg (SE)
(74) Representative: Lecomte & Partners
(86) International application number: PCT/EP2010/070647
(87) International publication number: WO 2012/084048

(56) References cited:
- EP-A1- 1 804 281
- JP-A- 2004 084 059
- JP-A- 2010 199 374
- US-A1- 2009 229 855
- KAWATA H ET AL: "SI ETCHING WITH HIGH ASPECT RATIO AND SMOOTH SIDE PROFILE FOR MOLD FABRICATION", JAPANESE JOURNAL OF APPLIED PHYSICS, JAPAN SOCIETY OF APPLIED PHYSICS, JP, vol. 45, no. 6B, 1 June 2006 (2006-06-01), pages 5597-5601, XP001502465, ISSN: 0021-4922, DOI: DOI:10.1143/JJAP.45.5597
- VOLLAND B ET AL: "Dry etching with gas chopping without rippled sidewalls", JOURNAL OF VACUUM SCIENCE & TECHNOLOGY B: MICROELECTRONICSPROCESSING AND PHENOMENA, AMERICAN VACUUM SOCIETY, NEW YORK, NY, US, vol. 17, no. 6, 1 November 1999 (1999-11-01), pages 2768-2771, XP012007814, ISSN: 0734-211X, DOI: DOI:10.1116/1.591061

## Description

### FIELD OF THE INVENTION

The present invention relates to a method for providing an ECPR master electrode. More particularly, the present invention relates to an etching method for providing a topographical pattern on such ECPR master electrode.

### BACKGROUND ART

WO 02/103085 and WO 2007058603 relate to an electrochemical pattern replication process, ECPR, and the construction of a master electrode for production of appliances involving micro and nano structures using ECPR. An etching or plating pattern, which is defined by the master electrode, is replicated on an electrically conductive material, commonly denoted as a substrate. During ECPR, the master electrode is put in close contact with the substrate and the etching/plating pattern is directly transferred onto the substrate by an etching/plating process. The contact etching/plating process is performed in local etching/plating cells, which are formed in cavities between the master electrode and the substrate.

The cavities are provided as electrochemical cells having an open end at the upper surface of the master electrode, and extending downwards. Hence, the upper surface of the master electrode includes a topographical pattern defining at least one electrochemical cell, wherein the bottom of each cell is provided with an electrically conducting material. During ECPR, each cell is filled with an electrolyte solution, for allowing conducting ions of the conducting material to be transferred from the bottom of each cell to the substrate to be patterned.

The area between the electrochemical cells, i.e. the uppermost area of the topographical pattern of the master electrode is provided with an insulating layer for preventing unwanted parasitic currents during the ECPR process. Hence, ECPR will only provide pattern transfer at the positions being defined by the electrochemical cells.

Before the master electrode is used in the ECPR, the electrochemical cells need to be prefilled with a conductive material. Usually, the thickness of the prefilled material is in the range of 0,5 to 5 microns depending on the specific application. During the ECPR the conductive material is transferred from the bottom of the electrochemical cells of the master electrode to the substrate being plated. Thus, when the master electrode is separated from the processed substrate the prefilled conductive material is arranged on the substrate.

The master electrode may be made of a durable material, since the master electrode should be used for a plurality of processes of etching or plating. One such material is Si, which allows the master electrode to be manufactured by well established and high yield semiconductor processes.

The electrochemical cells must have a depth being larger than the thickness of the prefilled conductive material, in order to allow complete plating. For ECPR, it is common to provide electrochemical cells being up to 30 microns in depth, depending on the particular application. In order to provide such trenches, deep etch processes must be applied. Silicon etching may be done using reactive ion etching, however the radicals used in such process are also very aggressive on the mask layer. Such deep etch thus requires a very thick etch mask, which is undesirable for many reasons. Another approach is to switch the gases used in the reactive ion etch, such that an etch sequence is followed by a passive making step. By doing such alternation, very deep etching may be achieved still having a relative thin mask layer.

However, the use of such etch/passive making process, so called scalloping is induced. This is not desirable, since the profile of the trench is critical in order to be able to separate the master electrode from the plated substrate after ECPR.

Hence, there is a need for an improved method for etching the trenches in order to provide electrochemical cells having a positive profile without scalloping and irregularities causing damages to the substrate and/or the master electrode during separation after ECPR.

### SUMMARY OF THE INVENTION

Accordingly, the present invention seeks to mitigate, alleviate or eliminate one or more of the above-identified deficiencies and to provide an improved method for manufacturing a master electrode.

It is an object of the invention to provide an ECPR master electrode having a topographical pattern defining at least one electrochemical cell, which cell allows for facilitated separation of the master electrode from the substrate after ECPR.

It is a further object of the present invention to provide a method for manufacturing such master electrode using a simple etch process, which may be done by standard semiconductor process equipment.

An idea of the present invention is to provide deep trenches in the master electrode by using a two-step process.

According to a first aspect of the invention, a method according to claim 1 for providing a topographical pattern on a conducting or semiconducting carrier element of an ECPR master electrode is provided. The method comprises the steps of providing an etch mask on a front side of said carrier element; and etching said front side of said carrier element according to an reactive ion etch sequence, wherein said sequence comprises i) etching a first part of a trench of said carrier element using a predetermined set of constant etch parameters, and ii) etching a second part of said trench using a repeated cycle of a predetermined set of alternating etch parameters.

The etch depth of one cycle in (ii) may be less than or equal to the etch depth of said first part in (i). This is advantageous in that multiple cycles may be performed during ii) for providing a very controlled etch depth.

Said cycle may comprise an etching step and a following passivation step, which is advantageous in that very high etch selectivity between the carrier element and the etch mask may be achieved.

The depth of said first part of said trench may be larger than or equal to the thickness of material to be transferred during the ECPR process. Hence, after ECPR the plated material is only occupying the first portion, thus facilitating separation of the master electrode from the plated substrate.

Said cycle may be repeated for at least ten times. The etch depth of said first part may further be between 1 and 20 microns, and the etch depth of each cycle may be between 0,005 and 1 microns. Hence, the scalloping which is provided due to the cyclic etch sequence is kept relatively small, thus reducing the risk of formation of defects during the etch sequence.

Said predetermined set of etch parameters may include etch gas, gas flow, power, time, and pressure. This is advantageous in that standard RIE equipment may be used for providing a master electrode of sufficient quality.

According to a second aspect of the invention, an ECPR master electrode according to claim 8 is provided. The master electrode comprises a carrier element having an electrically conducting electrode surface on a back side and a topographical pattern with an at least partly electrically insulating top on a front side, said topographical pattern is forming at least one electrochemical cell in the carrier element, said electrochemical cell comprising a bottom and at least one side wall, said bottom having an electrically conducting surface being conductively connected to the electrically conducting electrode surface on the back side through the carrier element, wherein said at least one side wall extends from said front side to said bottom along a profile having a first portion and a second portion, the shape of said first portion being different from the shape of said second portion.

Said first portion has a straight profile, and said second portion comprises at least one undercut profile. Preferably, the first portion may have a smooth sidewall without scallops on the nanometer scale and a vertical or positive sidewall angle, whilst the second portion may have a scalloped sidewall due to the cyclical etch process employed.

The depth of said first portion may be equal to or larger than the thickness of the conductive material to be transferred during the ECPR process.

The advantages of the first aspect of the invention are also applicable for the second aspect of the invention.

### BRIEF DESCRIPTION OF THE DRAWINGS

Hereinafter, the invention will be described with reference to the appended drawings, wherein:
Fig. 1a - d are schematic side views of a master electrode and a substrate before, during, and after ECPR;
Fig. 2a - c are schematic side views of an electrochemical cell of an ECPR master electrode according to prior art;
Fig. 3 is a side view of a section of an ECPR master electrode according to an embodiment; and
Fig. 4 is a method scheme of a manufacturing process of an ECPR master electrode according to an embodiment.

### DESCRIPTION OF EMBODIMENTS

Below, several embodiments of the invention will be described with references to the drawings. These embodiments are described in illustrating purpose in order to enable a skilled person to carry out the invention and to disclose the best mode. However, such embodiments do not limit the invention, but other combinations of the different features are possible within the scope of the claims. Some general remarks are given below with regard to the master electrode and methods of forming the master electrode. Several methods are described for forming a master electrode that can be used for producing one or multiple layers of structures of one or multiple materials including using the ECPR technology described below. The methods generally include: forming a master electrode from a carrier element which is conducting and/or semiconducting in at least some parts; forming a conducting electrode layer which functions as anode in ECPR plating and cathode in ECPR etching on a front side of the master electrode; and forming an insulating pattern layer that defines the cavities in which ECPR etching or plating can occur in the ECPR process on said front side, such that conducting electrode surface(s) is/are obtained in the bottom of the cavities; in a way that makes possible electrical contact from an external power supply to the back side of the master electrode for allowing electron transfer through the master electrode to the front side thereof to the conducing electrode surface(s), such that said surface(s) will constitute anode(s) in ECPR plating and cathode(s) in ECPR etching.

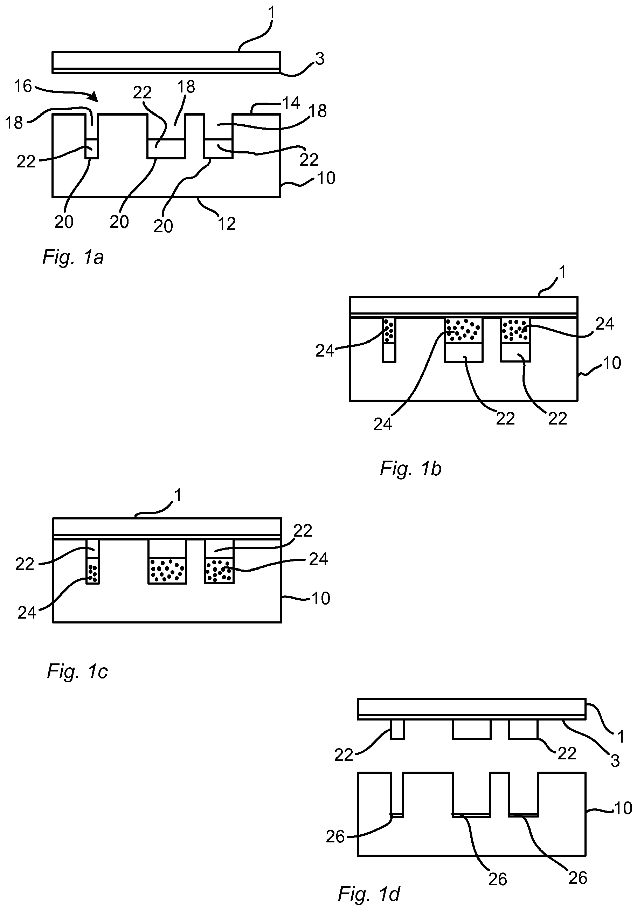

Now referring to Fig. 1a - d, a schematic side view of an ECPR is shown. Starting with Fig. 1a, a substrate 1 is on one side coated with an electrically conducting layer 3. The electrically conducting layer 3 is generally denoted as a seed layer. A master electrode 10 is provided and aligned with the substrate 1 in an ECPR chamber (not shown). The master electrode has a back side 12 being provided with an electrode layer (not shown), and a front side 14 including a topographic pattern 16 forming a plurality of electrochemical cells 18. Each cell 18 extends from the front side 14 of the master electrode 10 towards the back side 12, and has a bottom 20 of an electrically conductive material. Each cell 18 is further pre-filled with a bulk 22 of electrically conductive material, to be transferred to the substrate 1 during the ECPR.

In Fig. 1b, the substrate 1 is brought into close contact with the master electrode 10. This is done in an environment comprising an electrolyte 24, such that said electrolyte is trapped within the cavities formed by the electrochemical cells 18 of the master electrode, said cells 18 being closed by the seed layer 3 of the substrate 1.

During ECPR, the bulk of electrically conductive material 22 is transferred to the seed layer 3 of the substrate 1 by applying a voltage to the substrate/master electrode sandwich. This is shown in Fig. 1c.

After the ECPR, the substrate 1 is separated from the master electrode 10 and the electrolyte is removed from the electrochemical cells 18. As is shown in Fig. 1d, the pre-filled bulk material 22 is now deposited onto the seed layer 3 of the substrate 1, and the pattern transfer is finalized. A thin layer of electrically conductive material 26 is still left at the bottom 20 of each electrochemical cell 18 for allowing the master electrode to be pre-filled by a plating process. The master electrode is then again ready for a new ECPR.

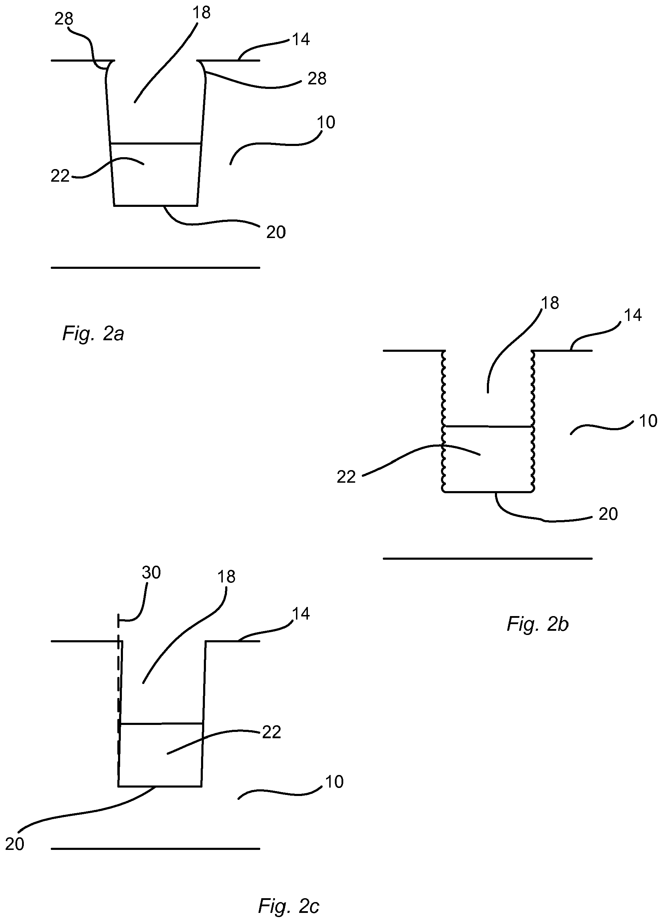

In Fig. 2a - c, different shapes of an electrochemical cell 18 are shown. The different shapes are due to different etching processes, which will be described in further detail. It should however be noticed that the drawings are not to scale, since the thickness of the master electrode 10 is substantially greater than the depth of the electrochemical cells 18. In a typical embodiment, the thickness of the master electrode 10 is between 200 and 2000 microns, while a typical depth of the electrochemical cells 18 is in the range of 5 to 25 microns.

Starting with Fig. 2a, the electrochemical cell 18 is formed as a trench in the carrier element of the master electrode 10. The electrochemical cell 18 is to some extent occupied by a bulk 22 of a conductive material to be transferred to a substrate during the ECPR. The electrochemical cell 18 extends from the bottom 20 to the front side 14 of the master electrode. The trench is created by an etch process, such as reactive ion etch, in which radical ions are dissolving the material of the carrier element. The trench has a positive tapered profile, which means that the width of the trench is larger at the open end than at the bottom 20. Further, the trench has an undercut profile 28 which is provided due to isotropic characteristics of the initial phase of the etching process.

In Fig. 2b, the trench has vertical sidewalls following an undulated pattern, known as scalloping. Such scalloping is well known in the art and due to an etching process which rapidly alternates between an etching step and a subsequent passive making step. Each etching step provides an isotropic etch, while the passive making step is used to enhance the chemical resistance of the etch mask.

In Fig. 2c, the trench has sidewalls of a smooth and straight profile, however they are tilted relative a vertical line 30 being perpendicular to the front side 14 of the master electrode 10. This may be the case if the etch equipment is not perfectly aligned with the carrier element to be etched, such that the electrical field of the etching chamber does not force the radical ions to hit the carrier element perpendicular to the plane of the front side 14.

For each of the trenches described with reference to Figs. 2a - c, the separation of the substrate from the master electrode will be very difficult without damaging the master electrode or the processed substrate. This is due to the fact that the transferred bulk material will be trapped by the trench profile, thus hindering the substrate from being pulled away from the master electrode, and vice versa.

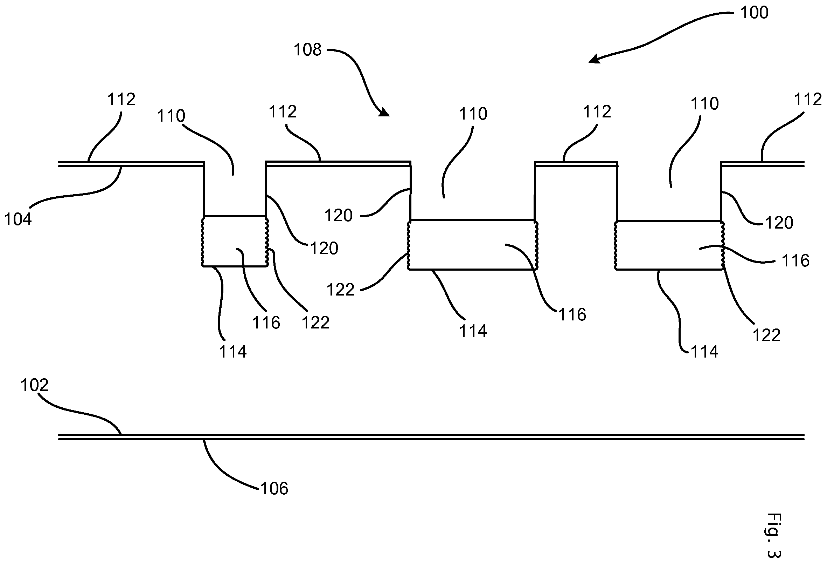

Now turning to Fig. 3, a schematic side view of a master electrode 100 according to an embodiment is shown. Again, the figure is not to scale but shown only to illustrate the main features of the master electrode.

The master electrode 100 is formed by a semiconducting carrier element having a back side 102 and a front side 104. The back side is covered by an electrode layer 106 and the front side comprises a topographic pattern 108 forming a plurality of electrochemical cells 110. An insulating layer 112 is arranged on the front side 104 for preventing current to flow from the electrode layer 106 to the front side 104.

Each electrochemical cell 110 extends from a bottom 114 to the front side 104, and is partly filled with a bulk material 116 of an electrically conductive material. The side walls 118 of each electrochemical cell 110 extend from the front side 104 to the bottom 114 along a profile having a first portion 120 and a second portion 122, the shape of said first portion 120 being different from the shape of said second portion 122. Preferably, the first portion 120 has a positive tapered profile with smooth sidewalls, such as a substantially planar tapered shape. Further, the first portion 120 is deeper than the thickness of material to be transferred to the substrate during the ECPR process. The shape of the conductive material transferred during the ECPR process is thereby a replication of the shape of the first portion 120. The smooth sidewall and positive angle of the region 120 facilitates separation of the master electrode and substrate.. The second portion 122 may comprise of at least one undercut profile, or a sidewall with scalloping. The combined depth of 120 and 122 should be larger than the thickness of the conductive prefilled material in order to allow for ECPR transfer.

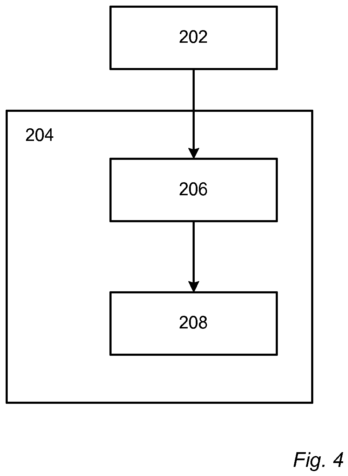

The manufacturing method of the described master electrode 100 will now be described with reference to Fig. 4. The method 200 includes a first step 202, in which a carrier element, such as a semiconducting wafer, is provided with an etch mask. This may be done by any suitable lithography equipment, and including the steps of resist coating, mask alignment, exposure, development, and rinsing. The choice of etch mask may vary depending on the particular application, and the step 202 may further include the procedure of transferring the resist pattern to an already deposited layer of e.g. silicon nitride, wherein said layer of silicon nitride is forming the etch mask.

In a second step 204, the carrier element is arranged in an etching chamber, preferably a reactive ion etch, in which etching of the trenches occurs. Step 204 is divided into an initial process 206, in which the operation of the etch equipment is set according to constant predetermined etch parameters for providing a homogenous etch sequence. The etching parameters may e.g. include etch gas, gas flow, power, time, and pressure of the reactive ion etch equipment. Hence, a first portion of the trench will be provided and the profile of the first portion may be controlled very accurate with respect to etch depth, tapering, and smoothness of the side walls. Consequently, said first portion may be designed to have smooth sidewalls following a slightly positive profile, having a tapering of 80 - 90°. The depth of the trench will be at least as deep as the thickness of material to be transferred during the ECPR process. However, such process will drastically reduce the thickness of the etch mask.

In a following step 208, the etch parameters are changed to follow a repeated cycle of a predetermined set of alternating etch parameters, wherein an etch sequence is followed by a passive making step. Hence, the etch rate of the mask is reduced such that a deep trench may be provided without the need for an increased thickness of the etch mask. Typically, the cycle is repeated for a number of times to achieve the desired trench depth, e.g. 20 - 500. Although scalloping may occur during the step 208, this is considered as non-critical since it will not affect the separation of the master electrode from the substrate after ECPR.

The provision of further features of the master electrode, such as the conducive layer at the bottom of each trench, the electrode layer on the back side, and further layers of insulating materials may be performed prior or after the method 200.

The described method has been successful in providing a master electrode formed by a carrier element of silicon and having electrochemical cells being approximately 30 microns deep, wherein a first portion of each electrochemical cell is 15 microns deep and a second portion of each electrochemical cell is 15 microns deep. The first portion has a slightly positive and smooth profile for allowing a simple separation of the master electrode from the substrate, while the second portion has a scalloping profile which does not affect the separation process. However, the second portion is allowing a very fast and reliable etch process, wherein the etch mask may be kept relatively thin throughout the etch process. Further, the etching of the second portion reduces the formation of pillars at the bottom of the trenches, which may be formed due to deposition of etch resistant compounds at the bottom of the trenches during etching of the first portion. The etch processes described above may include the use of O₂, SF₆, NF₃, XeF₂, Cl₂, HBr, CHF₃, CH₃F, C₄F₈, C₅F₈, C₂F₆, but other gases may also be used.

It is readily understood that all references to lower/upper are merely for illustrative purposes, without any limiting effect on the scope of protection. Moreover, it should be realized that equivalent setups to those described may include setups having a substrate arranged on a lower chuck while the master electrode is mounted on an upper chuck, as well as setups in which the positions of the lower and upper chuck are switched.

In the claims, the term "comprises/comprising" does not exclude the presence of other elements or steps. Additionally, although individual features may be included in different claims, these may possibly advantageously be combined, and the inclusion in different claims does not imply that a combination of features is not feasible and/or advantageous. In addition, singular references do not exclude a plurality. The terms "a", "an", "first", "second" etc do not preclude a plurality. Reference signs in the claims are provided merely as a clarifying example and shall not be construed as limiting the scope of the claims in any way.

## Claims

1. A method (200) for providing a topographical pattern on a conducting or semiconducting carrier element of an ECPR master electrode, comprising the steps of: providing (202) an etch mask on a front side of said carrier element; and etching (204) said front side of said carrier element according to an reactive ion etch sequence, **characterized in that** said sequence comprises:
i) etching (206) a first part of a trench of said carrier element using a predetermined set of constant etch parameters, and
ii) etching (208) a second part of said trench using a repeated cycle of a predetermined set of alternating etch parameters.

2. The method according to claim 1, wherein the etch depth of one cycle in (ii) is less than or equal to the etch depth of said first part in (i).

3. The method according to claim 1 or 2, wherein said cycle comprises an etching step and a following passivation step.

4. The method according to any one of claims 1 to 3, wherein the depth of said first part of said trench is larger than or equal to the thickness of material to be transferred during the ECPR process.

5. The method according to any one of claims 1 to 4, wherein said cycle is repeated for at least ten times.

6. The method according to any one of claims 1 to 5, wherein the etch depth of said first part is between 1 and 20 µm, and wherein the etch depth of each cycle is between 0,005 and 1 µm.

7. The method according to any one of claims 1 to 6, wherein said predetermined set of etch parameters includes etch gas, gas flow, power, time, and pressure.

8. An ECPR master electrode (100), comprising a carrier element having an electrically conducting electrode surface (106) on a back side (102) and a topographical pattern (108) with an at least partly electrically insulating top (112) on a front side (104), said topographical pattern (108) is forming at least one electrochemical cell (1 10) in the carrier element, said electrochemical cell comprising a bottom (114) and at least one side wall, said bottom (114) having an electrically conducting surface being conductively connected to the electrically conducting electrode surface (106) on the back side (102) through the carrier element, **characterized in that** said at least one side wall extends from said front side (104) to said bottom (114) along a profile having a first portion (120) and a second portion (122), the shape of said first portion (120) being different from the shape of said second portion (122),
wherein said first portion (120) has a straight profile, and wherein said second portion (122) comprises at least one undercut profile.

9. The ECPR master electrode according to claim 8, wherein the depth of said first portion is equal to or larger than the thickness of the conductive material to be transferred during the ECPR process.

## Patentansprüche

1. Verfahren (200) zur Anbringung eines topographischen Musters auf einem leitenden oder halbleitenden Trägerelement einer ECPR-Masterelektrode, umfassend folgende Schritte: Anbringen (202) einer Ätzmaske auf einer Vorderseite des Trägerelements; und Ätzen (204) der Vorderseite des Trägerelements gemäß einer Abfolge von reaktivem lonenätzen, **dadurch gekennzeichnet, dass** die Abfolge umfasst:
i) Ätzen (206) eines ersten Teils eines Grabens des Trägerelements unter Anwendung eines vorgegebenen Satzes konstanter Ätzparameter, und
ii) Ätzen (208) eines zweiten Teils des Grabens unter Anwendung eines wiederholten Zyklus eines vorgegebenen Satzes alternierender Ätzparameter.

2. Verfahren nach Anspruch 1, wobei die Ätztiefe eines Zyklus in (ii) kleiner oder gleich der Ätztiefe des ersten Teils in (i) ist.

3. Verfahren nach Anspruch 1 oder 2, wobei der Zyklus einen Ätzschritt und einen nachfolgenden Passivierungsschritt umfasst.

4. Verfahren nach einem der Ansprüche 1 bis 3, wobei die Tiefe des ersten Teils des Grabens größer oder gleich der Dicke des während des ECPR-Prozesses zu übertragenden Materials ist.

5. Verfahren nach einem der Ansprüche 1 bis 4, wobei der Zyklus mindestens zehn Mal wiederholt wird.

6. Verfahren nach einem der Ansprüche 1 bis 5, wobei die Ätztiefe des ersten Teils zwischen 1 und 20 µm beträgt und wobei die Ätztiefe jedes Zyklus zwischen 0,005 und 1 µm beträgt.

7. Verfahren nach einem der Ansprüche 1 bis 6, wobei der vorgegebene Satz von Ätzparametern Ätzgas, Gasströmung, Energie, Zeit und Druck beinhaltet.

8. ECPR-Masterelektrode (100), umfassend ein Trägerelement, das eine elektrisch leitende Elektrodenfläche (106) an einer Rückseite (102) und ein topographisches Muster (108) mit einer mindestens teilweise elektrisch isolierenden Oberseite (112) an einer Vorderseite (104) aufweist, wobei das topographische Muster (108) mindestens eine elektrochemische Zelle (110) in dem Trägerelement bildet, wobei die elektrochemische Zelle einen Boden (114) und mindestens eine Seitenwand umfasst, wobei der Boden (114) eine elektrisch leitende Oberfläche aufweist, die leitend mit der elektrisch leitenden Elektrodenfläche (106) an der Rückseite (102) durch das Trägerelement hindurch verbunden ist, **dadurch gekennzeichnet, dass** die mindestens eine Seitenwand sich von der Vorderseite (104) zu dem Boden (114) entlang einem Profil erstreckt, das einen ersten Abschnitt (120) und einen zweiten Abschnitt (122) aufweist, wobei die Form des ersten Abschnitts (120) von der Form des zweiten Abschnitts (122) verschieden ist,
wobei der erste Abschnitt (120) ein gerades Profil aufweist und wobei der zweite Abschnitt (122) mindestens ein unterschnittenes Profil umfasst.

9. ECPR-Masterelektrode nach Anspruch 8, wobei die Tiefe des ersten Abschnitts gleich der oder größer als die Dicke des während des ECPR-Prozesses zu übertragenden leitenden Materials ist.

## Revendications

1. Procédé (200) pour procurer un motif topographique sur un élément conducteur ou semi-conducteur faisant office de support d'une électrode de référence de type ECPR, comprenant les étapes consistant à : procurer (202) un masque de gravure sur un côté avant dudit élément faisant office de support ; et graver (204) ledit côté avant dudit élément faisant office de support conformément à une séquence de gravure par ions réactifs ; **caractérisé en ce que** ladite séquence comprend le fait de :
i) graver (206) une première partie d'une tranchée dudit élément faisant office de support en utilisant un jeu prédéterminé de paramètres de gravure constants ; et
ii) graver (208) une deuxième partie de ladite tranchée en utilisant un cycle répété d'un jeu prédéterminé de paramètres de gravure alternés.

2. Procédé selon la revendication 1, dans lequel la profondeur de gravure d'un cycle dans (ii) est inférieure ou égale à la profondeur de gravure de ladite première partie dans (i).

3. Procédé selon la revendication 1 ou 2, dans lequel ledit cycle comprend une étape de gravure et une étape de passivation qui y fait suite.

4. Procédé selon l'une quelconque des revendications 1 à 3, dans lequel la profondeur de ladite première partie de ladite tranchée est supérieure ou égale à l'épaisseur de matière qui doit être transférée au cours du processus ECPR.

5. Procédé selon l'une quelconque des revendications 1 à 4, dans lequel ledit cycle est répété au moins 10 fois.

6. Procédé selon l'une quelconque des revendications 1 à 5, dans lequel la profondeur de gravure de ladite première partie se situe entre 1 et 20 µm ; et dans lequel la profondeur de gravure de chaque cycle se situe entre 0,005 et 1 µm.

7. Procédé selon l'une quelconque des revendications 1 à 6, dans lequel ledit jeu prédéterminé de paramètres de gravure englobe le gaz de gravure, le courant de gaz, la puissance, la durée et la pression.

8. Électrode de référence (100) de type ECPR, comprenant un élément faisant office de support possédant une surface électroconductrice d'électrode (106) sur un côté arrière (102) et un motif topographique (108) comprenant un sommet (112) procurant une isolation électrique au moins partielle, sur un côté avant (104), ledit motif topographique (108) formant au moins une pile électrochimique (110) dans l'élément faisant office de support, ladite pile électrochimique comprenant une base (114) et au moins une paroi latérale, ladite base (114) possédant une surface électroconductrice reliée en conductivité à la surface d'électrode électroconductrice (106) sur le côté arrière (102) à travers l'élément faisant office de support, **caractérisée en ce que** ladite au moins une paroi latérale s'étend à partir dudit côté avant (104) jusqu'à ladite base (114) en suivant un profil possédant une première portion (120) et une deuxième portion (122), la configuration de ladite première portion (120) étant différente de la configuration de ladite deuxième portion (122) ; dans laquelle ladite première portion (120) possède un profil rectiligne ; et dans laquelle ladite seconde portion (122) comprend au moins un profil de contre-dépouille.

9. Électrode de référence de type ECPR selon la revendication 8, dans laquelle la profondeur de ladite portion est égale ou supérieure à l'épaisseur du matériau conducteur qui doit être transférée au cours du processus ECPR.
